Europäisches Patentamt

European Patent Office

Office européen des brevets

(11) Publication number: **0 272 743**
**A2**

## (12) EUROPEAN PATENT APPLICATION

(21) Application number: **87202496.3**

(22) Date of filing: **14.12.87**

(51) Int. Cl.⁴ **H01L 23/40**

(30) Priority: **19.12.86 IT 2415486 U**

(43) Date of publication of application:
**29.06.88 Bulletin 88/26**

(84) Designated Contracting States:
**AT BE CH DE ES FR GB GR IT LI LU NL SE**

(71) Applicant: **SGE BOSARI S.r.l.**
**Viale Europa, 77**
**I-20090 Cusago Milano(IT)**

(72) Inventor: **Gavotti, Nicolò Luigi**
**Viale Europa 77**
**I-20090 Cusago Milano(IT)**

(74) Representative: **Riccardi, Sergio**
**Riccardi & Co. Via Macedonio Melloni, 32**
**I-20129 Milano(IT)**

(54) **Improved device for clamping together a semiconductor and its related heat sink.**

㊼ Improved device for clamping together a semiconductor and its related heat sink, characterised by the fact that it is constituted by a pair of bar clamps, provided with packs of calibrated springs, which clamp the radiator onto the semiconductor with the desired uniform pressure, requiring for mounting the removal of only two small areas of the heat sink for the passage of the bar clamps.

Fig.1

EP 0 272 743 A2

# IMPROVED DEVICE FOR CLAMPING TOGETHER A SEMICONDUCTOR AND ITS RELATED HEAT SINK

This invention concerns an improved device for providing optimal clamping of power semiconductors and their heat sinks, achieving a very high degree of thermal coupling between the heat source cell and the cooling fluid, and simultaneously avoiding costly and difficult operations on the elements which make up the cooling system.

All the electrically active parts of power apparatuses dissipate heat by the Joule effect but in percentages which are very different according to the function performed in the equipment. Therefore, not only semiconductors but also resistors, inductors, transformers, bars and cabling, must be able to dissipate the heat generated in accordance with a thermal balance which guarantees that the temperature of the component is kept within the correct working limits.

It is obvious that the problem and the cost of cooling become much greater when the aforesaid limit is restricted and the surface of the component which can dissipate the heat is small. This simple fact explains why attention is mainly focused on semiconductors when the size of the cooling system is evaluated. These components are characterised by the fact that they have relatively low maximum working temperatures (of the order of 100°C inside the component) and have very small surface areas as a result of miniaturisation.

It must be remembered that, in the '50s, the volume of mercury vapour rectifiers often amounted to cubic metres while today these have been replaced by solid state diodes whose volume has been reduced by a factor of between 100 and 1,000.

The heat dissipated by high power semiconductors is of the order of hundreds or thousands of watts. It is, therefore, logical that the problem of getting rid of the heat that is generated is something which cannot be neglected.

Manufacturers of these components have, therefore, directed their efforts from the very start towards improving the constructional shapes of semiconductor devices, particularly bolt and washer semiconductors which permit the application of radiators or other cooling systems and which lend themselves to techniques of heat removal which have the maximum possible efficiency.

Generally, this efficiency is obtained by continuously improving the integration between the semiconductors and the dissipating devces, in other words achieving closer and closer thermal coupling between the source of heat and the cooling fluids.

Mounting of washer semiconductors requires the use of a particular system of clamping, using thermal contact between the cell and the heat dissipater by the exertion of a given pressure.

This particular system is known by its English name the bar clamp. It is constituted by a pair of tie-rods connected by a brace which, in turn, presses on a transversal bar by means of a central pressure regulation screw. It is this transversal bar which clamps the semiconductor to the radiator, generally against a second lower bar, with or without a relative transversal bar which completes the desired clamping system.

It is very important for the pressure to be calibrated to the value indicated by the semiconductor manufacturer and for the pressure to be exerted perpendicularly in the geometric centre of the cell. This is to ensure good electrical performance and minimum thermal coupling resistance between the semiconductor and the heat dissipator.

The typical bar clamp which is currently used requires the use of a radiator which has a mounting aperture or the use of the more efficient finned radiators, in which case the fins in the whole area between the two tie-rods must be drilled which is a difficult and costly operation.

In both cases, the fins of the radiator are missing in the very area in which they would be of most use i.e in correspondence to the point where the heat is generated.

The objective of the present invention is to solve this problem and to create a clamping device which achieves even better thermal contact and which, when used instead of the traditional bar clamps, will permit considerable savings in the amount of mechanical work required on heat sinks.

The device according to this invention solves this problem brilliantly and in the best possible way. It is basically constituted by a pair of bar clamps provided with packs of calibrated springs which clamp the raditator to the semiconductor with the desired identical force, the clamping pressure being identifiable immediately from the position of a reference mark in a ring nut inserted in the tie bar.

Since the pressure exerted by the two tie bars is absolutely equal, the resulting force is applied exactly at the geometrical centre of the cell, the transversal bar and all the other elements which couple the two rods become superfluous and there is no need to remove the fins of the radiator above the semiconductor.

Since all these transversal elements have been eliminated, by analogy with the traditional terminology, this device can well be called the "barless clamp". Thus, to utilise this device, only the fins in two circular areas of a small diameter in correspondence to the two clamps have to be removed, leaving the fins above the heat source in place thus producing functional and economic benefits which are obvious.

Drilling two round holes is obviously a simple and fast operation compared to the work that is necessary for a traditional bar clamp. In addition, the system of calibrating the barless clamp according to this invention is extremely simple since the calibration pressure, identified by the coloured ring marked on the ring nut, is obtained by screwing down the tie bar when the ring nut is no longer free to move.

The insulator of the barless clamp is capable of withstanding very high voltages (1,000 Volts at 50 Hz for 60 seconds). No special tools of any kind are required for mounting, not even a torque wrench, since the operation is simple and safe.

The scope, characteristics and advantages of the clamping device according to this invention have already been clearly explained in the preceding description. They will become even more evident from the following detailed description of its preferential embodiment which is provided here as a non-limiting example and with reference made to the figures in the attached illustrative drawings, in which:

Figure 1 is a view of a traditional bar clamp system showing in particular the area of the radiator which must be removed for its application.

Figure 2 is a similar view of the barless clamp system of this invention applied to the same type of radiator as the one in Figure 1; and

Figure 3 is an enlarged view showing the various component parts of the barless clamp of this invention.

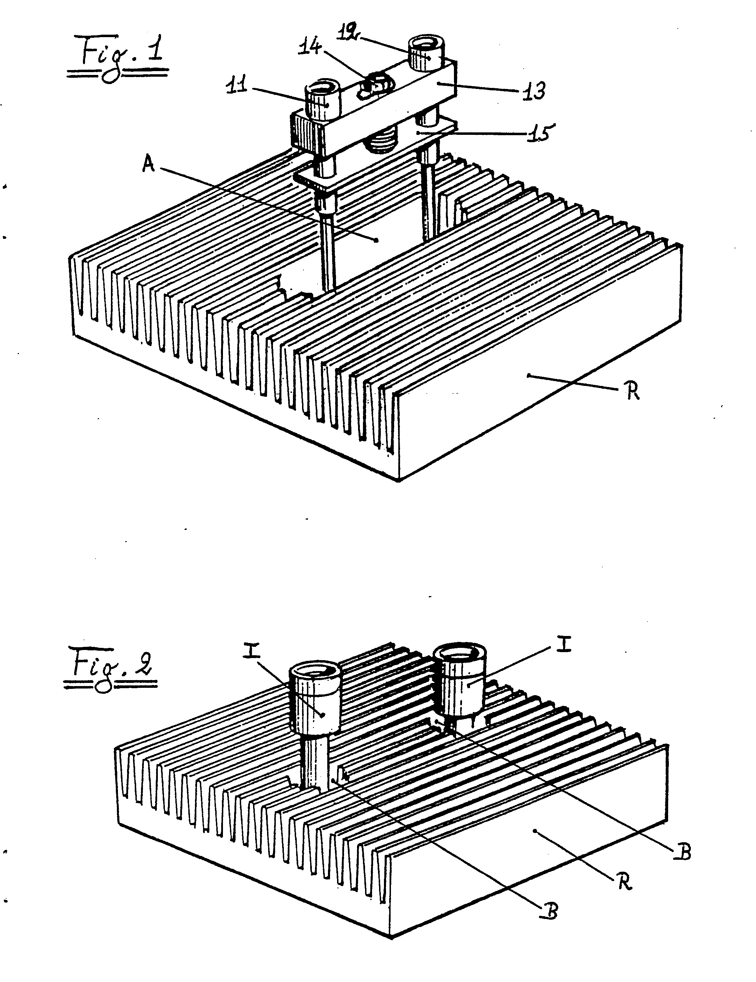

Looking first at Figure 1, one can clearly see that, in order to mount a conventional bar clamp, constituted by two tie rods 11 and 12 with brace 13, regulating screw 14 and bar 15, on a finned radiator R, the whole of Area A has had to be removed, that is to say the area above the semiconductor where heat dissipation is most necessary.

Looking at Figure 2, one can see that when the bar clamp I of this invention is used, which has eliminated all the transversal connecting elements between the tie rods, only the two small circular areas B have had to be removed to allow the passage of the rods. Therefore, the enormous improvement in the dissipation of the heat produced by the semiconductor is obvious. While the illustration shows the mounting of the device of this invention on a finned radiator, it is clear that it can be applied to any type of heat sink for semiconductors.

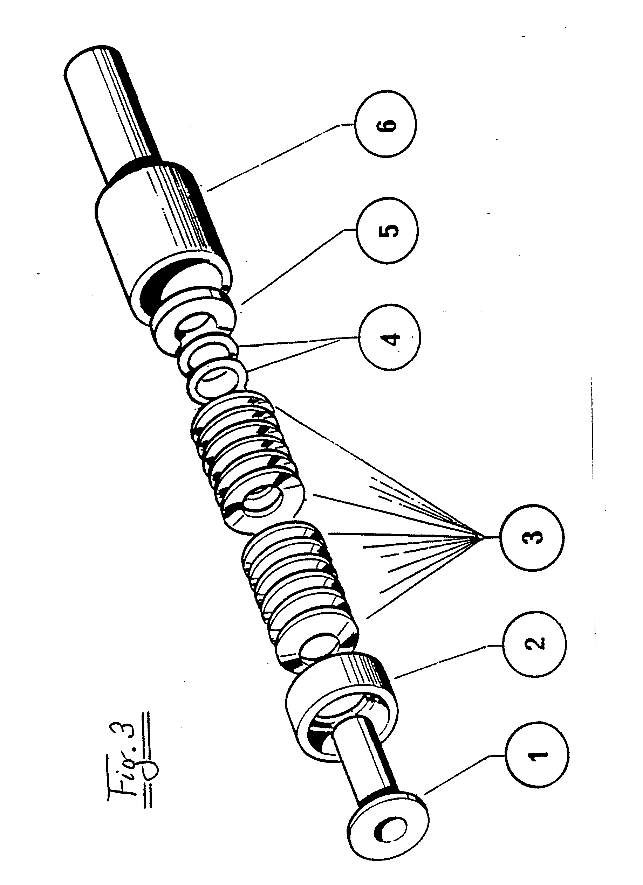

Finally, referring to Figure 3, it can clearly be seen that each of the two tie-rods which constitute the barless clamp device according to the present invention comprises a coupler 1, a ring nut 2, two opposed series of springs 3, between which the radiator is clamped, a group of one or more calibrated distance washers 4, an ordinary washer 5 and a high voltage insulator 6. The ring nut has a reference mark preferably in the form of a coloured band, so that the operator can actually see when the calibration pressure has been reached, in other words when the ring nut can no longer move freely.

Thus, one can see that the clamping device according to the present invention fully meets the objective, but it must also be understood that numerous variations, modifications, additions and/or substitutions of components can be made without prejudice to the spirit and scope of this invention and without prejudice to the scope of protection which is clearly defined in the attached claims.

**Claims**

1. Improved device for clamping together a semiconductor and its related heat sink, characterised by the fact that it is constituted by a pair of bar clamps, provided with packs of calibrated springs which clamp the radiator onto the semiconductor with the desired uniform pressure, requiring for mounting the removal of only two small areas of the heat sink for the passage of the bar clamps.

2. Device according to claim 1, characterised by the fact that each tie-rod comprises a coupler, a ring nut, two counterposed series of springs, one or more calibrated distance washers, one ordinary washer and a high voltage insulator.

3. Device according to claim 2, characterised by the fact that the ring nut is provided with a reference mark which gives a visual indication when calibration pressure is reached in other words when the tie-rod is screwed down by the ring nut, it is no longer free to move.

4. Device according to claim 3, characterised by the fact that the reference mark is constituted by a coloured band.

5. Improved device for clamping together a semiconductor and its related heat sink, as described previously and as illustrated in the figures in the attached illustrated drawings, for the objectives specified above.

Fig. 1

Fig. 2

Fig. 3